# EUROPEAN PATENT SPECIFICATION

(11) **EP 1 763 043 B1**
(45) Date of publication and mention of the grant of the patent: **17.03.2010**
(21) Application number: 05425635.9
(22) Date of filing: 09.09.2005
(51) Int. Cl.: H01F 17/00, H01F 41/04, H01L 23/64, H01L 21/02

(54) **Inductive structure**
Induktive Anordnung
Structure inductive

(43) Date of publication of application: 14.03.2007
(73) Proprietor: STMicroelectronics S.r.l., 20041 Agrate Brianza (Milano) (IT)
(72) Inventor: Ripamonti, Giancarlo, 20133 Milano (IT); Pulici, Paolo, 20025 Legnano (MI) (IT); Vanalli, Gian Pietro, 24030 Almenno San Bartolomeo (BG) (IT); Lessio, Tito, 20092 Cinisello B. mo (MI) (IT); Stoppino, Pier Paolo, 20124 Milano (IT)
(74) Representative: Botti, Mario

(56) References cited:
- US-A- 6 054 329
- US-A1- 2004 212 475
- US-A1- 2005 005 424
- US-B1- 6 775 901

## Description

### Field of application

The present invention relates to an inductive structure.

More specifically, the invention relates to an inductive structure of the type comprising at least a winding comprising at least a coil and developed around a ferromagnetic core.

The invention also relates to a method for integrating an inductive structure in an electronic device package.

The invention particularly, but not exclusively, relates to a multichip device and the following description is made with reference to this field of application by way of illustration only.

### Prior art

As it is well known, the push to the integration has had a key role during the last years in the field of electronics.

In particular, the need of increasing the potentiality of an electronic apparatus without increasing the physical magnitude of the object comprising it has pushed, first of all, to reduce the geometric dimensions characteristics of the electronic devices in general (such as for example the channel length of MOSFET transistors).

Three-dimension circuit solutions have also been proposed, in particular exploiting the z dimension of electronic devices integrated in chip or die, i.e. a dimension orthogonal to a development plane of the chip, by packing, one above the other, more dice and leading to the emergence of the so called stacked devices or multichip.

The market needs and the new technological knowledge have allowed to realise, by exploiting both the above indicated solutions, i.e. the reduction of the geometric dimensions of the devices and their arrangement according to the z dimension, real systems inside a same package of integrated device, the so called Systems in Package, hereafter indicated with SIP.

It is also known that, in the field of multichip devices and of SIP, in case the application had required an inductor of considerable values (higher than some nH), constructors of the multichip device or SIP have provided, up to now, the use of an external discrete component suitably connected by the final user by means of an external PCB, with subsequent increase of the dimensions and of the constructive and use complication of the device itself.

In fact, the discrete inductors currently on sale with significant saturation currents (higher than 0,5A) and with inductance value around µH have such dimensions that they cannot be integrated in a SIP. Generally, when the final thickness alleys are particularly narrow (lower than 1,5mm), the discrete components, so as to be integrated in a package, must have greatest dimensions equal to a SMD0402 (0,5 mm x 1 mm and 0,5 mm of thickness) thus with thickness lower than 700 µm. The discrete inductors with inductance values in the order of the ten of µH and with saturation currents higher than 0,5A have instead thickness higher than 1mm.

In the field the need is thus strongly felt of realising an inductor with considerable inductance value (in particular, higher than some nH) directly integrated in a package of integrated circuit for realising a multichip device, such as a stacked device or a SIP.

A known technical solution to meet this need is described in the US patent No. 6,775,901 granted on August 17, 2004 in the name of Hai Young Lee et al..

Such document describes an inductor realised with the bonding wires thanks to the presence of pairs of bonding terminals or pads realised on a substrate of a semiconductor device and of one or more bonding wires configured so as to realise a ring and thus an inductive winding. An injection step is also provided of an epoxy resin to complete the package containing the inductor thus realised.

Although advantageous under several aspects, this solution shows some drawbacks. For example, it is immediately evident that the inductor thus realised has a non-confined magnetic field, risking to jeopardise the operation of the integrated system wherein it is realised.

Also known from the US patent application published under No. 2005/0005424 in the name of Nuytkens et al., which is regarded as the closest prior art, is a method of manufacturing planar inductors comprising the steps of electroplating to add thicker layer of less conductive ferromagnetic material to a core which is formed at least in part by electroless plating. In particular, the ferroelectric layers are formed by dipping the dielectric surface in a solution containing catalytic metal particles. It is to be noted that such proposed method is deeply tied to the features of the layer whereon the ferroelectric layers are formed.

The technical problem underlying the present invention is that of devising an integrated inductive structure having such structural and functional characteristics as to realise geometric structures of electronic components integrated in a multichip and which use the magnetic properties of one or more coils, simultaneously overcoming the limits and the drawbacks still affecting the devices realised according to the prior art.

### Summary of the invention

The solution idea underlying the present invention is that of realising a winding around a ferromagnetic core realised by means of a multilayer structure of a ferromagnetic material deposited on a package substrate of a multichip device, such as for example a SIP or a stacked device. In particular, the winding comprises at least a coil realised by exploiting the bonding wires and/or the tracks of a first metallisation layer of the package substrate of the multichip device.

On the basis of this solution idea the technical problem is solved by an inductive structure as previously indicated and defined by the characterising part of claim 1.

The problem is also solved by a method for integrating a inductive structure as previously indicated and defined by the characterising part of claim 25.

The characteristics and the advantages of the inductive structure according to the invention will be apparent from the following description of an embodiment thereof given by way of indicative and non limiting example with reference to the annexed drawings.

### Brief description of the drawings

In these drawings:
Figure 1A schematically shows an inductive structure integrated in a multichip device and realised according to the invention;
Figure 1B shows, in greater detail, a detail of the inductive structure of Figure 1A;
Figure 2 schematically shows the pattern of the magnetic field inside the ferromagnetic material of the inductive structure of Figure 1A;
Figure 3 shows, in greater detail, the inductive structure of Figure 1A;
Figure 4 schematically shows an application of the inductive structure according to the invention suitable to implement a transformer;
Figure 5 schematically shows a further application of the inductive structure according to the invention suitable to implement an inductive sensor;
Figures 6A and 6B schematically show further applications of the inductive structure according to the invention suitable to implement an inductive relay;
Figure 7 schematically shows a further embodiment of a detail of the inductive structure of Figure 1;
Figure 8 schematically shows a multichip device equipped with an inductive structure realised according to the invention.

### Detailed description

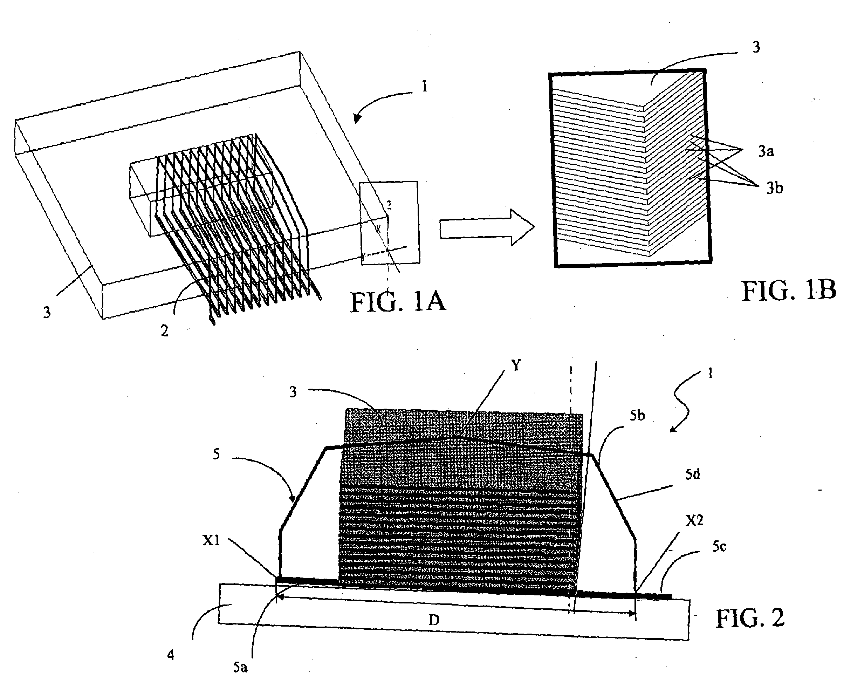

With reference to these figures, and in particular to Figure 1, an inductive structure realised according to the invention is globally and schematically indicated at 1.

In particular, the inductive structure 1 comprises a winding 2 developed around a ferromagnetic core 3.

Advantageously according to the invention, the ferromagnetic core 3 is realised by a ferromagnetic structure suitably arranged above a package substrate so as to be contained inside the winding 2, as it will be clarified hereafter in the description, this package comprising besides the inductive structure 1 at least a further electronic device.

Suitably, the ferromagnetic structure is realised by means of a multilayer 3 obtained by overlapping different layers 3a of flat ferromagnetic material overlapped and glued onto each other, as shown in Figure 1B, and it thus allows to obtain a ferromagnetic core of desired dimensions for the inductive structure 1.

In other words, the multilayer ferromagnetic structure 3 according to the invention comprises an overlapping of layers 3a of flat ferromagnetic material and of layers 3b of insulating material, suitably adhesive, alternated with each other, its realisation resulting to be easily inserted in an integration process of a multichip device, as it will be clarified hereafter in the description.

Advantageously, being the used ferromagnetic band very thin, a quite accurate control of the final thickness of the toroidal core is possible.

It is to be remarked that, advantageously according to the invention, the multilayer ferromagnetic structure 3 inserted inside the winding 2 allows to confine the magnetic field of the inductive structure 1 and not to notably influence the interconnections close thereto inside a package.

In a preferred embodiment, the multilayer ferromagnetic structure 3 has a closed configuration, substantially ring-shaped, as shown in Figure 1A. In particular, in the example shown in this figure, the multilayer ferromagnetic structure 3 is substantially a rectangular plate equipped with a central opening, also preferably rectangular.

The multilayer ferromagnetic structure 3 advantageously allows to obtain significant inductance values for the integrated inductor realised by the inductive structure 1 and thus it allows its use inside a package for integrated circuits, the multilayer ferromagnetic structure 3 being deposited on a package substrate 4, as shown in greater detail in Figure 2.

Only by way of example it is remarked that the multilayer ferromagnetic structure 3 has been realised in the ferromagnetic material commercially available with the name VITROVAC 6150. This material has relative magnetic mobilities equal to 1300 and, in the configuration shown in Figure 1A, allows to implement an integrated inductor of 15µH with saturation currents close to the Ampere.

Since the thickness of the ferromagnetic layers or bands 3a of VITROVAC 6150 on sale is equal to 25µm, to obtain the multilayer ferromagnetic structure 3 of suitable thickness, different layers of this material have been overlapped, suitably glued to each other.

It is possible to verify that, with a multilayer ferromagnetic structure 3 having thickness equal to 750 µm, obtained for example by overlapping fifteen layers 3a of ferromagnetic material, as shown in Figure 1B, in integrated inductor is realised having inductance value equal to 17,4 µH.

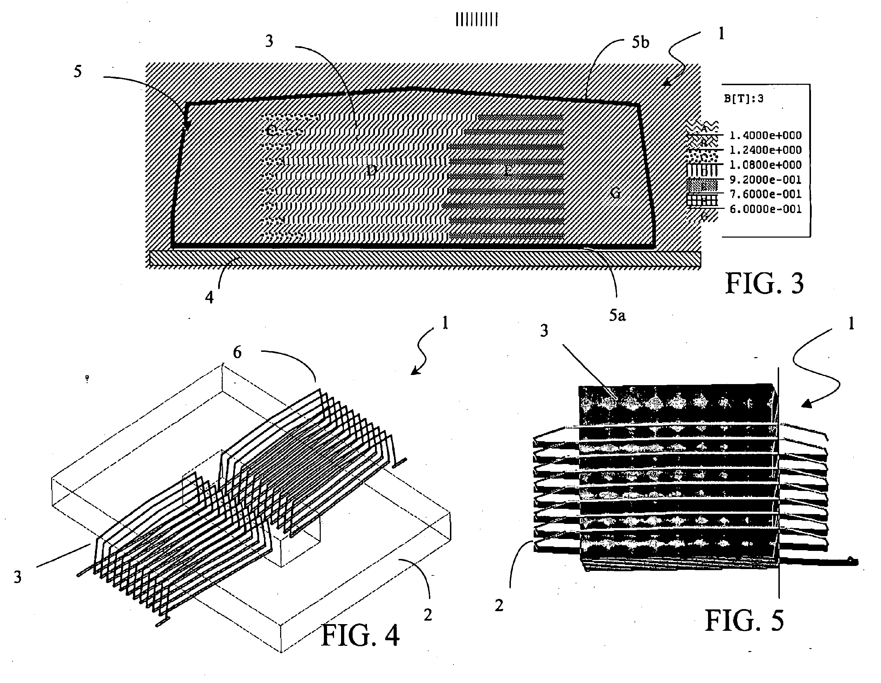

The pattern of the magnetic field inside the multilayer ferromagnetic structure 2 so obtained is schematically shown in Figure 3 and it results to be in the order 1T with highest current equal to 0,6A and parasite resistance equal to 3,5 Ohm.

In particular, the inductive structure 1 comprises a winding 2 equipped with a plurality of coils 5, each one comprising a first portion 5a, comprising for example a length portion D of a metallisation line 5c realised on the package substrate 4, as well as a second portion 5b, made for example of a bonding wire 5d, joined to each other in a ring-like configuration to form the coil 5, as shown in Figure 3. In particular the bonding wire 5d connects a first X1 and a second end X2 of the portion 5a of the metallisation line 5c so as to form the coil 5.

Advantageously according to the invention, the multilayer ferromagnetic structure 3 is arranged above the package substrate 4 so as to be contained inside the coil 5. In particular the multilayer ferromagnetic structure 3 is arranged above the metallisation line 5c, within the first and the second ends X1 and X2 of the same, the bonding wire 5d suitably passing above this structure 3 to connect the first and the second ends X1 and X2.

It is to be noted that the winding is not a closed path, in other words if the ends X1 and X2 are interconnected by using the first metal level of the substrate, they are not interconnected through a bonding wire so as to allow that the current flows in the winding in a desired way.

Moreover, advantageously according to the invention, the multilayer ferromagnetic structure 3 is suitably coated, at least in correspondence with a lower face thereof, arranged next to the package substrate 4 and to an upper face thereof, arranged next to an apical point Y of the bonding wire 5d, by means of an electrically insulating glue layer so as not to create conductive short-circuits between the coils.

In a preferred embodiment of the integrated inductive structure 1 according to the invention, this electrically insulating glue layer is arranged on all the faces of the multilayer ferromagnetic structure 3. Preferably the entire multilayer ferromagnetic structure 3 is coated with an electrically insulating glue.

Advantageously, to realise the integrated inductor in a multichip device by means of the inductive structure 1 according to the invention, the rules for the positioning of the bondfingers (not shown since conventional) and of the bonding wires used for the realisation of a generic multichip device are suitably respected, so as not to have any problems of short-circuits between the bonding wires in consequence of the resin injection and of the moulding carried out on the multichip device itself.

Possibly, if the application requires a quality factor characteristic of the integrated inductor being higher than the one that can be obtained with the configuration described with reference to Figure 1A, it is possible to double the bonding wires starting from each bondfinger so as to reduce the global resistance of the winding 2, by means of a parallel path of two bonding wires.

The integrated inductor realised by means of the inductive structure described finds advantageous application, for example, in step-up voltage converters where it is used to carry out switches of an operative voltage. The sole limitations of the integrated inductor thus obtained for these applications are constituted by the characteristics of the ferromagnetic material used and they are linked to the highest switch frequency of the magnetisation of the material itself and to the saturation magnetic field.

Advantageously according to the invention, the inductive structure 1 is also suitable to implement a transformer, as schematically shown in Figure 3. The transformer comprises, in particular, a multilayer ferromagnetic structure 3, which can be suitably realised on a package substrate of a multichip device in case the transformer is integrated in such multichip device, whereon a first or primary winding 2 and a second or secondary winding 6 are arranged, both realised as previously described and comprising pluralities of coils also realised as already described.

In a way known to a technician of the field, the number of coils comprised in the primary 2 and secondary windings 6 allow to dimension the transformer obtained by means of the inductive structure 1 as desired. Also in this case, advantageously according to the invention, the multilayer ferromagnetic structure 3 has a closed configuration, substantially ring-like shaped, in particular with rectangular plan and equipped with a central opening, also preferably rectangular.

Thus, advantageously according to the invention, it is possible to realise a transformer suitable to be comprised in a package of multichip device, in particular a stacked device or a SIP.

Considered the geometric characteristics of the bonding wire (which normally has a section equal to 25µm) and the rules tidying the routing in the substrate of the multichip device, the transformer realised by the integrated inductive structure 1 according to the invention can be used for frequencies higher than the tens of kHz.

Possibly, by using bonding wires with greater sections it is possible to realise transformers operating even at lower frequency than the one indicated.

The integrated inductive structure 1 is also suitable to implement a sensor schematically shown in Figure 5. In this case, the multilayer ferromagnetic structure 3 has a substantially bar-like shape, in particular squared, with the coils of the winding 2 wound thereon.

The sensor configuration shown in Figure 5 is able to realise a proximity sensor based on the magnetic field, a passage sensor or also a position sensor to be applied to a stator or to a rotor of a robot motor.

In fact, by measuring the current induced in the sensor so realised by the integrated inductive structure 1 according to the invention, the variation of the magnetic flux linked with its winding 2 can be determined.

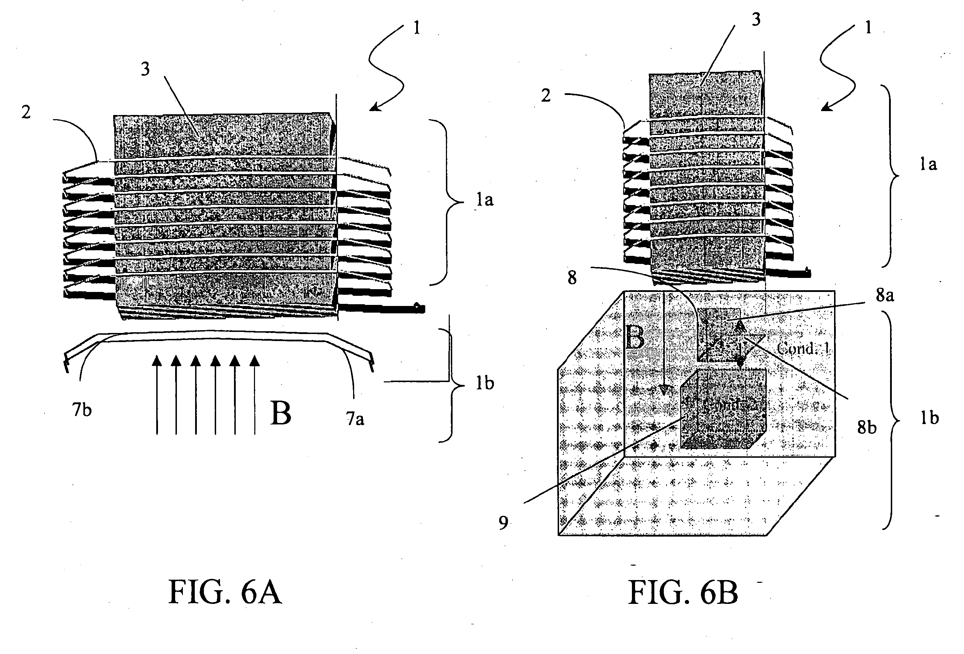

Advantageously according to the invention, the integrated inductive structure 1 can be used for realising a relay, schematically shown in Figures 6A and 6B.

The integrated inductive structure 1 implementing the relay comprises, in this case, a first portion 1a configured as the sensor of Figure 5 and comprising in turn a multilayer ferromagnetic structure 2 whereon a winding 2 is wound as well as a second portion 1b, in particular a triggering portion, substantially suitable to realise a switch.

In the example of Figure 6A, the triggering portion 1b essentially comprises a first bonding wire 7a, in particular realised with material sensitive to the magnetic field, such as for example iron or nickel, as well as a further non-ferromagnetic wire 7b (shown in Figure 6A by a second bonding wire 7b).

In this way, by applying a current onto the winding 2 of the first portion 1a, it is possible to generate a magnetic field B outside the multilayer ferromagnetic structure 3. If the first bonding wire 7a is placed inside this magnetic field B, it moves and it can thus can generate a contact with the other wire 7b.

It is however important to underline that in this case the use of the two different materials for the bonding wires (one being ferromagnetic, the other not) is to be provided. Moreover, the contact surface between the two wires could be reduced, implying quite a high parasite contact resistance.

In a further advantageous embodiment of the integrated inductive structure 1 suitable to implement a relay, schematically shown in Figure 6B, the triggering portion 1b comprises a first wire 8 and a second switch 9.

In particular, the first wire 8 is a mobile element able to create the electric contact with the second wire 9. In the embodiment shown in Figure 6B, the first wire 8 is realised by means of a strip 8a of ferromagnetic material equipped with a metallic tongue 8b and the second wire 9 is a switch. In case a magnetic field B is applied, inside the triggering portion 1b a force is generated able to move the metallic tongue 8b in the direction of the second wire 9: it is thus possible to short-circuit the two wires 8 and 9 and to have through them a current flow.

Both the wires 8 and 9 are glued with a conductive glue (or welded) on a pad of the package substrate of a multichip device with which the integrated inductive structure 1 suitable to implement the relay is integrated and in this way they are short-circuited with the relative connection. By inverting the direction of the current flowing in the winding 2 of the first portion 1a of the inductive structure 1 it is possible to move away the two wires 8 and 9 and to easy the opening of the switch realised by the second portion 1b.

It is to be noted that for both the embodiments of the inductive structures 1 suitable to implement a relay, the triggering portion 1b comprises a ferromagnetic contact which should be free to move. Therefore, the area wherein this inductive structure 1 is realised does not have to be covered by resin. Advantageously according to the invention, the inductive structure 1 thus comprises a protective plastic casing for the area of the mobile contact. In a preferred embodiment of the inductive structure 1 according to the invention, inside this protective area the void is created so as to avoid problems of oxidation of the metallic and ferromagnetic contacts.

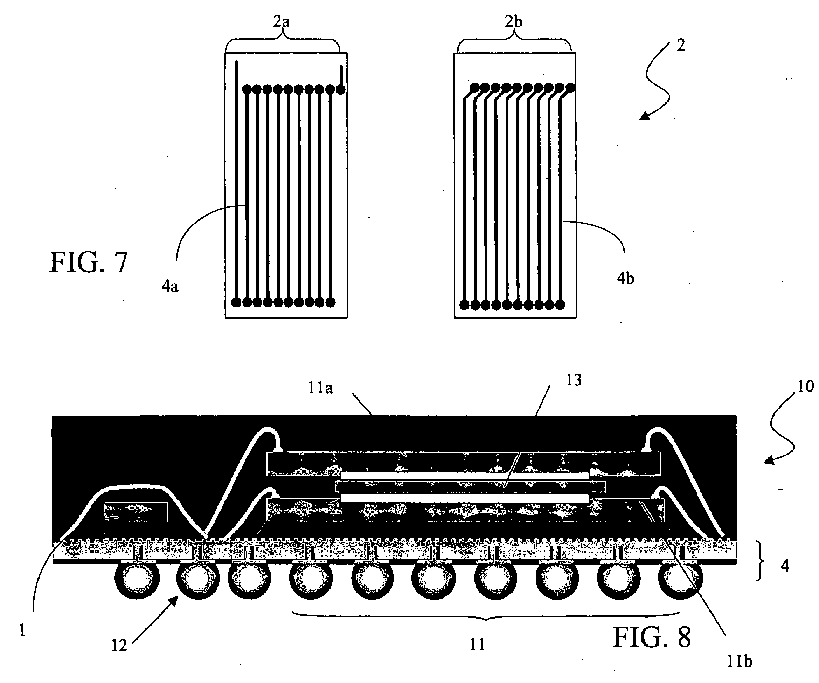

In a further embodiment, shown with reference to Figure 7, the winding 2 is realised without exploiting the bonding wires, but through suitable routing of a first and of a second plurality of tracks in different layers of the package substrate of the multichip device wherein the winding 2 is integrated. In particular, a first portion 2a of the winding 2 comprising this first plurality of tracks and realised in a first layer 4a of the package substrate 4 and a second portion 2b comprising this second plurality of tracks and realised in a second layer 4b of the package substrate 4, suitable vias being provided for the contact of said pluralities of tracks.

It is also possible to interpose, between this first 4a and second layer 4b, a suitable ferromagnetic material for increasing the magnetic potentialities of the winding 2 thus obtained.

Figure 8 schematically shows a section of a multichip device, in particular a SIP 10 comprising at least an integrated inductive structure 1 realised according to the invention, suitable to implement an inductor, a sensor or a relay.

In particular, the SIP 10 comprises the integrated inductive structure 1 realised next to a stack 11 of a first 11a and of a second chip 11b, mounted on a package substrate 4, in particular equipped with a ball grid array 12, and possibly separated by an interposer 13.

The present invention also relates to a method for integrating an inductive structure 1 on a package substrate 4, in particular in a multichip device such as a stacked device or a SIP. The method according to the invention comprises the steps of:
- providing a package substrate 4;
- realising, in this package substrate 4, at least one metallisation line 5c;
- integrating, on the package substrate 4, at least one electronic device, in particular a chip stack 11.

Advantageously according to the invention, the method also provides the steps of:
- realising, on this package substrate 4, an inductive structure 1 next to this chip stack 11.

In particular, this step of realising an integrated inductive structure 1 comprises the steps of:
- depositing a multilayer ferromagnetic structure 3 on this package substrate 4 next to this chip stack 11; and
- realising at least one coil 5 of a winding 2 of this integrated inductive structure 1 by means of an electric connection of a portion 5a of this metallisation line 5c.

In particular, the electric connection of a first X1 and of a second end X2 of the portion 5a of the metallisation line 5c is carried out by means of bonding above the multilayer ferromagnetic structure 3, as shown in Figures 1A and 2. In particular, a bonding wire 5d is connected to the first X1 and to the second end X2 of the portion 5a of the metallisation line 5c in a ring-like configuration to form the coil 5, as shown in Figure 3. In particular the coil 5 comprises a first portion corresponding to the portion 5a of the metallisation line 5c and a second portion comprising the bonding wire 5d joined to each other to form a ring and thus a coil 5 of the winding 2.

In a very obvious way, it is possible to realise a winding 2 comprising a plurality of coils 5 by means of a plurality of metallisation lines and bonding wires.

In this case, the method according to the invention advantageously provides that this bonding step is realised simultaneously with at least one bonding step of the process flow suitable to realise the chip stack 11.

Alternatively, this electric connection of a first X1 and of a second end X2 of the portion 5a of the metallisation line 5c is realised through routing of at least one further portion of a further or second metallisation line realised in a second layer 4b of the package substrate 4 distinct from a first layer 4a of this package substrate 4 wherein the first metallisation line 5c is realised.

Also in this case, in a very obvious way, it is possible to realise a winding 2 comprising a plurality of coils 5 by means of a plurality of first and second metallisation lines.

Advantageously according to the invention, the method also provides that the step of depositing the multilayer ferromagnetic structure 3 of the package substrate 4 comprises the steps of:
- depositing a plurality of layers 3a of flat ferromagnetic material overlapped onto each other to form the multilayer ferromagnetic structure 3.

In a preferred embodiment, the method also provides that the step of depositing the multilayer ferromagnetic structure 3 on the package substrate 4 comprises the steps of:
- depositing a plurality of layers 3a of flat ferromagnetic material and a plurality of layers 3b of adhesive material, overlapped onto each other in an alternated way.

Advantageously according to the invention, this step of depositing the multilayer ferromagnetic structure 3 on the package substrate 4 is realised simultaneously with at least one step of depositing at least one chip of the stack.

For example a small block of ferromagnetic material being cut and already packed, to form a multilayer material, can be treated in an identical way as the "dices", i.e. it can be placed on the substrate with the suitable pick and place machines.

Finally, the method according to the invention comprises, before the step of realising the winding 2, at least one coating step of the multilayer ferromagnetic structure 3 by means of an insulating layer, in particular an insulating glue layer.

In particular, this coating step provides a deposition of this insulating layer on a lower face of the multilayer ferromagnetic structure 2, arranged next to the package substrate 4 and on an upper face thereof, opposite the lower face. Suitably, this insulating layer is deposited on all the faces of the multilayer ferromagnetic structure 2.

In substance, the inductive structure 1 proposed allows to realise an inductor, a transformer, a sensor and a relay inside a package of electronic device.

Thus, advantageously according to the invention, by using the proposed inductive structure 1, it is possible to increase the potentiality of the systems that can be realised in a package, for example by allowing the insertion inside the package of inductors with considerable inductance values suitable for particular applications and with saturation currents close to the Ampere, without risking to interfere in a significant way with the rest of the system integrated therewith.

## Claims

1. Inductive structure of the type comprising at least one winding (2) comprising at least one coil (5) and developed around a ferromagnetic core (3) said inductive structure (1) being integrated in a package of an electronic device (11), **characterised in that** said ferromagnetic core (3) is a multilayer realised by means of a ferromagnetic structure arranged above a substrate (4) of said package and comprises an overlapping of a plurality of layers (3a) of flat ferromagnetic material overlapped onto each other and a plurality of layers (3b) of insulating material, alternated to said plurality of layers (3a) of flat ferromagnetic material.

2. Inductive structure according to claim 1, **characterised in that** said layers (3b) of insulating material are realised in an adhesive material.

3. inductive structure according to claim 1, **characterised in that** said multilayer ferromagnetic structure (3) has a closed configuration, substantially ring-like shaped.

4. Inductive structure according to claim 1, **characterised in that** said at least one coil (5) comprises a first portion (5a) comprising a portion of a metallisation line (5c) realised in said package substrate (4), as well as a second portion (5b), said second portion (5b) connecting a first and a second end (X1, X2) of said first portion (5a) to form coils of a continuous winding.

5. Inductive structure according to claim 4, **characterised in that** said second portion (5b) comprises a bonding wire (5d).

6. Inductive structure according to claim 4, **characterised in that** said second portion (5b) comprises a portion of a further metallisation line realised in a layer (4b) of said package substrate (4) distinct from a layer (4a) of said package substrate (4) wherein said metallisation line (5c) is realised.

7. Inductive structure according to claim 6, **characterised in that** it comprises suitable contact vias of said metallisation line (5c) and of said further metallisation line.

8. Inductive structure according to claim 1, **characterised in that** it comprises an insulating coating layer for said multilayer ferromagnetic structure (3).

9. Inductive structure according to claim 8, **characterised in that** said insulating coating layer coats said multilayer ferromagnetic structure (3) in correspondence with a lower face thereof, arranged next to said package substrate (4) and to an upper face thereof, opposite to said lower face.

10. Inductive Structure according to claim 8, **characterised in that** said insulating coating layer coats said multilayer ferromagnetic structure (3) in correspondence with all the faces thereof.

11. Inductive structure according to claim 8, **characterised in that** said insulating coating layer comprises an electrically insulating glue layer.

12. Inductive structure according to claim 1, **characterised in that** it realises a transformer and **in that** it comprises a further winding (6) arranged above said multilayer ferromagnetic structure (3).

13. Inductive structure according to claim 12, **characterised in that** said multilayer ferromagnetic structure (3) has a closed configuration, substantially ring-like shaped.

14. Inductive structure according to claim 1, **characterised in that** it realises a sensor and **in that** said multilayer ferromagnetic structure (3) has a substantially bar-like shape.

15. Inductive structure according to claim 1, **characterised in that** it realises a relay and **in that** it comprises a first portion (1a) comprising said multilayer ferromagnetic structure (3) whereon said winding (2) is wound and a second triggering portion (1b) suitable to realise a switch.

16. Inductive structure according to claim 15, **characterised in that** said second triggering portion (1b) comprises at least a first wire (7a, 8) realised with a material sensitive to the magnetic field and with a second wire (7b, 9) arranged next to this first wire (7a), placed in turn inside a magnetic field (B) generate by said first portion (1a) and able to move su as to contact said second wire (7b).

17. Inductive structure according to claim 16, **characterised in that** said second wire (7b) is realised in a non-ferromagnetic material.

18. Inductive structure according to claim 16, **characterised in that** said first wire (7a) comprises a bonding wire.

19. Inductive structure according to claim 16, **characterised in that** said second wire (7b) comprises a bonding wire.

20. Inductive structure according to claim 16, **characterised in that** said first wire (8) comprises a strip (8a) of ferromagnetic material equipped with a metallic tongue (8b) able to move in a direction towards, respectively away from, said second conductor (9).

21. Inductive structure according to claim 20, **characterised in that** said first and second wire (8, 9) are glued with a conductive glue or welded on a pad of said package substrate (4).

22. Inductive structure according to claim 15, **characterised in that** said second triggering portion (1b) comprises a protective plastic casing.

23. Inductive structure according to claim 22, **characterised in that** in said protective plastic casing void is created.

24. Inductive structure according to claim 1, **characterised in that** said electronic device (11) is a multichip device.

25. Method for integrating an inductive structure (1) on a package substrate (4), of the type comprising the steps of:
- providing a package substrate (4);
- realising, in said package substrate (4), at least one metallisation line (5c) ;
- integrating, on said package substrate (4), at least one electronic device (11)
- realising, on said package substrate (4), an inductive structure (1) next to said electronic device (11), **characterised in that** said realisation step further comprising the steps of:
- depositing a multilayer ferromagnetic structure (3) on said package substrate (4) next to said electronic device; and
- realising at least one coil (5) nf a winding (2) of said integrated inductive structure (1) by means of an electric connection of a portion (5a) of said metallisation line (5c)
and **in that** said deposition step of said multilayer ferromagnetic structure (3) on said package substrate (4) comprises the steps of:
- depositing a plurality of layers (3a) of flat ferromagnetic material overlapped onto each other; and
- depositing a plurality of layers (3a) of flat ferromagnetic material and a plurality of layers (3b) of adhesive material, overlapped onto each other in an alternated way.

26. Method according to claim 25, **characterised in that** said electric connection step of a portion (5a) of said metallisation line (5c) comprises a bonding step for electrically connecting a first and a second end (X1, X2) of one of said portions (5a) of said metallisation line (5c), said bonding step being carried out above said multilayer ferromagnetic structure (3).

27. Method according to claim 26, **characterised in that** said bonding step can be realised simultaneously with at least one bonding step of process flow suitable to realise said electronic device (11).

28. Method according to claim 25, **characterised in that** said electric connection step of a portion (5a) of said metallisation line (5c) comprises a routing step of at least a further portion of a further metallisation line realised in a layer (4b) of said package substrate (4) distinct from said layer (4a) of said package substrate (4) wherein said metallisation line (5a) is realised.

29. Method according to claim 25, **characterised in that** said deposition, step of said multilayer ferromagnetic structure (3) on said package substrate (4) can be realised simultaneously with at least one realisation step of said electronic device (11).

30. Method according to claim 25, **characterised in that** it further comprises a coating step of said multilayer ferromagnetic structure (3) by means of an insulating layer.

31. Method according to claim 30, **characterised in that** said coating step involves a lower face of said multilayer ferromagnetic structure (3), arranged next to said package substrate (4) and an upper face thereof, opposite to said lower face.

32. Method according to claim 30, **characterised in that** said coating step involves all the faces of said multilayer ferromagnetic structure (3).

33. Method according to claim 30, **characterised in that** said electronic device (11) is a multichip device.

## Patentansprüche

1. Induktive Anordnung des Typs mit wenigstens einer Wicklung (2), die mindestens eine Spule (5) aufweist und um einen ferromagnetischen Kern (3) gewickelt ist, wobei die induktive Anordnung (1) in eine Baueinheit einer elektronischen Vorrichtung (11) integriert ist,
**dadurch gekennzeichnet, dass** es sich bei dem ferromagnetischen Kern (3) um ein mehrlagiges Gebilde handelt, das mittels einer ferromagnetischen Anordnung realisiert ist, die über einem Substrat (4) der Baueinheit angeordnet ist, und das eine Überlappung aus einer Mehrzahl von einander überlappenden Schichten (3a) aus flachem ferromagnetischen Material sowie aus einer Mehrzahl von Schichten (3b) aus isolierendem Material aufweist, die abwechselnd mit der Mehrzahl von Schichten (3a) aus flachem ferromagnetischen Material vorgesehen sind.

2. Induktive Anordnung nach Anspruch 1,
**dadurch gekennzeichnet, dass** die Schichten (3b) aus isolierendem Material in haftendem Material realisiert sind.

3. Induktive Anordnung nach Anspruch 1,
**dadurch gekennzeichnet, dass** die mehrlagige ferromagnetische Anordnung (3) eine geschlossene Konfiguration aufweist, die im Wesentlichen ringförmig ist.

4. Induktive Anordnung nach Anspruch 1,
**dadurch gekennzeichnet, dass** die mindestens eine Spule (5) einen ersten Bereich (5a), der einen Teil einer in dem Baueinheit-Substrat (4) realisierten Metallisierungsleitung (5c) aufweist, sowie einen zweiten Bereich (5b) besitzt, wobei der zweite Bereich (5b) ein erstes und ein zweites Ende (X1, X2) des ersten Bereichs (5a) miteinander verbindet, um Spulen einer kontinuierlichen Wicklung zu bilden.

5. Induktive Anordnung nach Anspruch 4,
**dadurch gekennzeichnet, dass** der zweite Bereich (5b) einen Bondverbindungsdraht (5d) aufweist.

6. Induktive Anordnung nach Anspruch 4,
**dadurch gekennzeichnet, dass** der zweite Bereich (5b) einen Teil einer weiteren Metallisierungsleitung aufweist, die in einer Schicht (4b) des Baueinheit-Substrats (4) realisiert ist, die von einer Schicht (4a) des Baueinheit-Substrats (4) getrennt ist, in der die Metallisierungsleitung (5c) realisiert ist.

7. Induktive Anordnung nach Anspruch 6,
**dadurch gekennzeichnet, dass** sie geeignete Kontaktlöcher der Metallisierungsleitung (5c) und der weiteren Metallisierungsleitung aufweist.

8. Induktive Anordnung nach Anspruch 1,
**dadurch gekennzeichnet, dass** sie eine isolierende Überzugsschicht für die mehrlagige ferromagnetische Anordnung (3) aufweist.

9. Induktive Anordnung nach Anspruch 8,
**dadurch gekennzeichnet, dass** die isolierende Überzugsschicht auf die mehrlagige ferromagnetische Anordnung (3) entsprechend einer Unterseite von dieser, die in unmittelbar Nähe von dem Baueinheit-Substrat (4) angeordnet ist, und einer der Unterseite entgegengesetzten Oberseite von dieser aufgebracht ist.

10. Induktive Anordnung nach Anspruch 8,
**dadurch gekennzeichnet, dass** die isolierende Überzugsschicht auf die mehrlagige ferromagnetische Anordnung (3) auf allen Seiten von dieser aufgebracht ist.

11. Induktive Anordnung nach Anspruch 8,
**dadurch gekennzeichnet, dass** die isolierende Überzugsschicht eine elektrisch isolierende Klebstoffschicht aufweist.

12. Induktive Anordnung nach Anspruch 1,
**dadurch gekennzeichnet, dass** sie einen Transformator bildet und dass sie eine weitere Wicklung (6) aufweist, die über der mehrlagigen ferromagnetischen Anordnung (3) angeordnet ist.

13. Induktive Anordnung nach Anspruch 12,
**dadurch gekennzeichnet, dass** die mehrlagige ferromagnetische Anordnung (3) eine geschlossene Konfiguration aufweist, die im Wesentlichen ringförmig ist.

14. Induktive Anordnung nach Anspruch 1,
**dadurch gekennzeichnet, dass** sie einen Sensor bildet und dass die mehrlagige ferromagnetische Anordnung (3) eine im Wesentlichen stabförmige Konfiguration aufweist.

15. Induktive Anordnung nach Anspruch 1,
**dadurch gekennzeichnet, dass** sie ein Relais bildet und dass sie einen ersten Bereich (1a) mit der mehrlagigen ferromagnetischen Anordnung (3), auf die die Wicklung (2) gewickelt ist, sowie einen zweiten, auslösenden Bereich (1 b) aufweist, der zum Realisieren eines Schalters geeignet ist.

16. Induktive Anordnung nach Anspruch 15,
**dadurch gekennzeichnet, dass** der zweite, auslösende Bereich (1 b) zumindest einen ersten Draht (7a, 8), der mit einem für das Magnetfeld empfindlichen Material realisiert ist, und einen in unmittelbarer Nähe von diesem ersten Draht (7a) angeordneten zweiten Draht (7b, 9) aufweist, der wiederum innerhalb eines von dem ersten Bereich (1a) erzeugten Magnetfeldes (B) angeordnet ist und sich in Berührung mit dem zweiten Draht (7b) bewegen kann.

17. Induktive Anordnung nach Anspruch 16,
**dadurch gekennzeichnet, dass** der zweite Draht (7b) in einem nicht ferromagnetischen Material realisiert ist.

18. Induktive Anordnung nach Anspruch 16,
**dadurch gekennzeichnet, dass** der erste Draht (7a) einen Bondverbindungsdraht aufweist.

19. Induktive Anordnung nach Anspruch 16,
**dadurch gekennzeichnet, dass** der zweite Draht (7b) einen Bondverbindungsdraht aufweist.

20. Induktive Anordnung nach Anspruch 16,
**dadurch gekennzeichnet, dass** der erste Draht (7a) einen Streifen (8a) aus ferromagnetischem Material aufweist, der mit einer metallischen Lasche (8b) ausgestattet ist, die in Richtung zu dem dem zweiten Leiter (9) hin bzw. von diesem weg beweglich ist.

21. Induktive Anordnung nach Anspruch 20,
**dadurch gekennzeichnet, dass** der erste und der zweite Draht (8, 9) mittels eines leitfähigen Klebstoffs verklebt sind oder mit einer Fläche des Baueinheit-Substrats (4) verschweißt sind.

22. Induktive Anordnung nach Anspruch 15,
**dadurch gekennzeichnet, dass** der zweite auslösende Bereich (1 b) ein schützendes Kunststoffgehäuse aufweist.

23. Induktive Anordnung nach Anspruch 22,
**dadurch gekennzeichnet, dass** in dem schützenden Kunststoffgehäuse ein Hohlraum gebildet ist.

24. Induktive Anordnung nach Anspruch 1,
**dadurch gekennzeichnet, dass** es sich bei der elektronischen Vorrichtung (11) um eine Multichip-Vorrichtung handelt.

25. Verfahren zum Integrieren einer induktiven Anordnung (1) an einem Baueinheit-Substrat (4), wobei es sich bei dem Verfahren um eines des Typs handelt, das folgende Schritte aufweist:
- Bereitstellen eines Baueinheit-Substrats (4);
- Realisieren von mindestens einer Metallisierungsleitung (5c) in dem Baueinheit-Substrat (4);
- Integrieren von mindestens einer elektronischen Vorrichtung (11) an dem Baueinheit-Substrat (4);
- Realisieren einer induktiven Anordnung (1) auf dem Baueinheit-Substrat (4) in unmittelbarer Nähe zu der elektronischen Vorrichtung (11), **dadurch gekennzeichnet, dass** der Realisierungsschritt ferner folgende Schritte aufweist:
- Aufbringen einer mehrlagigen ferromagnetischen Anordnung (3) auf dem Baueinheit-Substrat (4) in unmittelbarer Nähe zu der elektronischen Vorrichtung; und
- Realisieren von mindestens einer Spule (5) einer Wicklung (2) der integrierten induktiven Anordnung (1) mittels einer elektrischen Verbindung eines Bereichs (5a) der Metallisierungsleitung (5c);
und dass der Schritt des Aufbringens der mehrlagigen ferromagnetischen Anordnung (3) auf dem Baueinheit-Substrat (4) folgende Schritte aufweist:
- Aufbringen einer Mehrzahl von Schichten (3a) aus flachem ferromagnetischen Material in einander überlappender Weise; und
- Aufbringen einer Mehrzahl von Schichten (3a) aus flachem ferromagnetischen Material und einer Mehrzahl von Schichten (3b) aus haftendem Material in einander überlappender und einander abwechselnder Weise.

26. Verfahren nach Anspruch 25,
**dadurch gekennzeichnet, dass** der Schritt des elektrischen Verbindens eines Bereichs (5a) der Metallisierungsleitung (5c) einen Bondverbindungsschritt zum elektrischen Verbinden eines ersten und eines zweiten Endes (X1, X2) von einem der Bereiche (5a) der Metallisierungsleitung (5c) beinhaltet, wobei der Bondverbindungsschritt über der mehrlagigen ferromagnetischen Anordnung (3) ausgeführt wird.

27. Verfahren nach Anspruch 26,
**dadurch gekennzeichnet, dass** der Bondverbindungsschritt gleichzeitig mit mindestens einem Bondverbindungsschritt eines Prozessablaufs ausgeführt werden kann, der zum Realisieren der elektronischen Vorrichtung (11) geeignet ist.

28. Verfahren nach Anspruch 25,
**dadurch gekennzeichnet, dass** der Schritt des elektrischen Verbindens eines Bereichs (5a) der Metallisierungsleitung (5c) einen Schritt des Verlegens von zumindest einem weiteren Bereich einer weiteren Metallisierungsleitung beinhaltet, die in einer Schicht (4b) des Baueinheit-Substrats (4) realisiert ist, die von der Schicht (4a) des Baueinheit-Substrats (4) getrennt ist, in der die Metallisierungsleitung (5c) realisiert ist.

29. Verfahren nach Anspruch 25,
**dadurch gekennzeichnet, dass** der Schritt des Aufbringens der mehrlagigen ferromagnetischen Anordnung (3) auf dem Baueinheit-Substrat (4) gleichzeitig mit mindestens einem Realisierungsschritt der elektronischen Vorrichtung (11) ausgeführt werden kann.

30. Verfahren nach Anspruch 25,
**dadurch gekennzeichnet, dass** es ferner einen Schritt des Beschichtens der mehrlagigen ferromagnetischen Anordnung (3) mittels einer Isolierschicht beinhaltet.

31. Verfahren nach Anspruch 30,
**dadurch gekennzeichnet, dass** der Beschichtungsschritt an einer Unterseite der mehrlagigen ferromagnetischen Anordnung (3), die in unmittelbarer Nähe zu dem Baueinheit-Substrat (4) angeordnet ist, sowie an einer der Unterseite entgegengesetzten Oberseite von dieser ausgeführt wird.

32. Verfahren nach Anspruch 30,
**dadurch gekennzeichnet, dass** der Beschichtungsschritt an allen Seiten der mehrlagigen ferromagnetischen Anordnung (3) ausgeführt wird.

33. Verfahren nach Anspruch 30,
**dadurch gekennzeichnet, dass** es sich bei dem elektronischen Vorrichtung (11) um eine Multichip-Vorrichtung handelt.

## Revendications

1. Structure inductive du type comprenant au moins un enroulement (2) comprenant au moins une bobine (5) et développée autour d'un noyau ferromagnétique (3), ladite structure inductive (1) étant intégrée à un emballage d'un dispositif électronique (11), **caractérisée en ce que** ledit noyau ferromagnétique (3) est une multicouche réalisée au moyen d'une structure ferromagnétique agencée au-dessus d'un substrat (4) dudit emballage et comprend une superposition d'une pluralité de couches (3a) de matériau ferromagnétique plat superposées l'une sur l'autre et d'une pluralité de couches (3b) de matériau isolant en alternance avec ladite pluralité de couches (3a) de matériau ferromagnétique plat.

2. Structure inductive selon la revendication 1, **caractérisée en ce que** lesdites couches (3b) de matériau isolant sont réalisées dans un matériau adhésif.

3. Structure inductive selon la revendication 1, **caractérisée en ce que** ladite structure ferromagnétique multicouche (3) a une configuration fermée, sensiblement en forme d'anneau.

4. Structure inductive selon la revendication 1, **caractérisée en ce que** ladite au moins une bobine (5) comprend une première partie (5a) comprenant une partie d'une ligne de métallisation (5c) réalisée dans ledit substrat d'emballage (4), ainsi qu'une deuxième partie (5b), ladite deuxième partie (5b) connectant des première et deuxième extrémités (X1, X2) de ladite première partie (5a) pour former des bobines d'un enroulement continu.

5. Structure inductive selon la revendication 4, **caractérisée en ce que** ladite deuxième partie (5b) comprend un fil de liaison (5d).

6. Structure inductive selon la revendication 4, **caractérisée en ce que** ladite deuxième partie (5b) comprend une partie d'une autre ligne de métallisation réalisée dans une couche (4b) dudit substrat d'emballage (4) distincte d'une couche (4a) dudit substrat d'emballage (4) dans laquelle ladite ligne de métallisation (5c) est réalisée.

7. Structure inductive selon la revendication 6, **caractérisée en ce qu'**elle comprend des vias de contact appropriés de ladite ligne de métallisation (5c) et de ladite autre ligne de métallisation.

8. Structure inductive selon la revendication 1, **caractérisée en ce qu'**elle comprend une couche de revêtement isolant pour ladite structure ferromagnétique multicouche (3).

9. Structure inductive selon la revendication 8, **caractérisée en ce que** ladite couche de revêtement isolant couvre ladite structure ferromagnétique multicouche (3) en correspondance avec une face inférieure de celle-ci, agencée à côté dudit substrat d'emballage (4) et d'une face supérieure de celle-ci à l'opposé de ladite face inférieure.

10. Structure inductive selon la revendication 8, **caractérisée en ce que** ladite couche de revêtement isolant couvre ladite structure ferromagnétique multicouche (3) en correspondance avec toutes les faces de celle-ci.

11. Structure inductive selon la revendication 8, **caractérisée en ce que** ladite couche de revêtement isolant comprend une couche de colle électriquement isolante.

12. Structure inductive selon la revendication 1, **caractérisée en ce qu'**elle réalise un transformateur et **en ce qu'**elle comprend un autre enroulement (6) agencé au-dessus de ladite structure ferromagnétique multicouche (3).

13. Structure inductive selon la revendication 12, **caractérisée en ce que** ladite structure ferromagnétique multicouche (3) a une configuration fermée sensiblement en forme d'anneau.

14. Structure inductive selon la revendication 1, **caractérisée en ce qu'**elle réalise un capteur et **en ce que** ladite structure ferromagnétique multicouche (3) est sensiblement en forme de barre.

15. Structure inductive selon la revendication 1, **caractérisée en ce qu'**elle réalise un relais et **en ce qu'**elle comprend une première partie (1a) comprenant ladite structure ferromagnétique multicouche (3) sur laquelle ledit enroulement (2) est enroulé et une deuxième partie de déclenchement (1b) appropriée pour réaliser un commutateur.

16. Structure inductive selon la revendication 15, **caractérisée en ce que** ladite deuxième partie de déclenchement (1b) comprend au moins un premier fil (7a, 8) réalisé avec un matériau sensible au champ magnétique et avec un deuxième fil (7b, 9) agencé à côté de ce premier fil (7a), placé aussi à l'intérieur d'un champ magnétique (B) généré par ladite première partie (1a) et capable de se déplacer pour entrer en contact avec ledit deuxième fil (7b).

17. Structure inductive selon la revendication 16, **caractérisée en ce que** ledit deuxième fil (7b) est réalisé dans un matériau non ferromagnétique.

18. Structure inductive selon la revendication 16, **caractérisée en ce que** ledit premier fil (7a) comprend un fil de liaison.

19. Structure inductive selon la revendication 16, **caractérisée en ce que** ledit deuxième fil (7b) comprend un fil de liaison.

20. Structure inductive selon la revendication 16, **caractérisée en ce que** ledit premier fil (8) comprend une bande (8a) de matériau ferromagnétique munie d'une langue métallique (8b) capable de se déplacer dans une direction vers ledit deuxième conducteur (9), respectivement en direction opposée à ce deuxième conducteur (9).

21. Structure inductive selon la revendication 20, **caractérisée en ce que** lesdits premier et deuxième fils (8, 9) sont collés avec une colle conductrice ou soudés sur un patin dudit substrat d'emballage (4).

22. Structure inductive selon la revendication 15, **caractérisée en ce que** ladite deuxième partie de déclenchement (1b) comprend une enveloppe plastique protectrice.

23. Structure inductive selon la revendication 22, **caractérisée en ce qu'**un vide est créé dans ladite enveloppe plastique protectrice.

24. Structure inductive selon la revendication 1, **caractérisée en ce que** ledit dispositif électronique (11) est un dispositif à puces multiples.

25. Procédé pour intégrer une structure inductive (1) sur un substrat d'emballage (4) du type comprenant les étapes consistant à :
- fournir un substrat d'emballage (4) ;
- réaliser, dans ledit substrat d'emballage (4), au moins une ligne de métallisation (5c) ;
- intégrer, sur ledit substrat d'emballage (4), au moins un dispositif électronique (11) ;
- réaliser, sur ledit substrat d'emballage (4), une structure inductive (1) à côté dudit dispositif électronique (11), **caractérisé en ce que** ladite étape de réalisation comprend en outre les étapes consistant à :
- déposer une structure ferromagnétique multicouche (3) sur ledit substrat d'emballage (4) à côté dudit dispositif électronique ; et
- réaliser au moins une bobine (5) d'un enroulement (2) de ladite structure inductive intégrée (1) au moyen d'une connexion électrique d'une partie (5a) de ladite ligne de métallisation (5c) ;
et **en ce que** ladite étape de dépôt de ladite structure ferromagnétique multicouche (3) sur ledit substrat d'emballage (4) comprend les étapes consistant à :
- déposer une pluralité de couches (3a) de matériau ferromagnétique plat superposées l'une sur l'autre ; et
- déposer une pluralité de couches (3a) de matériau ferromagnétique plat et une pluralité de couches (3b) de matériau adhésif, superposées l'une sur l'autre en alternance.

26. Procédé selon la revendication 25, **caractérisé en ce que** ladite étape de connexion électrique d'une partie (5a) de ladite ligne de métallisation (5c) comprend une étape de liaison pour connecter électriquement des première et deuxième extrémités (X1, X2) de l'une desdites parties (5a) de ladite ligne de métallisation (5c), ladite étape de liaison étant effectuée au-dessus de ladite structure ferromagnétique multicouche (3).

27. Procédé selon la revendication 26, **caractérisé en ce que** ladite étape de liaison peut être réalisée simultanément avec au moins une étape de liaison de flux de processus approprié pour réaliser ledit dispositif électronique (11).

28. Procédé selon la revendication 25, **caractérisé en ce que** ladite étape de connexion électrique d'une partie (5a) de ladite ligne de métallisation (5c) comprend une étape d'acheminement d'au moins une autre partie d'une autre ligne de métallisation réalisée dans une couche (4b) dudit substrat d'emballage (4) distincte de ladite couche (4a) dudit substrat d'emballage (4) dans laquelle ladite ligne de métallisation (5c) est réalisée.

29. Procédé selon la revendication 25, **caractérisé en ce que** ladite étape de dépôt de ladite structure ferromagnétique multicouche (3) sur ledit substrat d'emballage (4) peut être réalisée simultanément avec au moins une étape de réalisation dudit dispositif électronique (11).

30. Procédé selon la revendication 25, **caractérisé en ce qu'**il comprend en outre une étape de revêtement de ladite structure ferromagnétique multicouche (3) au moyen d'une couche isolante.

31. Procédé selon la revendication 30, **caractérisé en ce que** ladite étape de revêtement implique une face inférieure de ladite structure ferromagnétique multicouche (3) agencée à côté dudit substrat d'emballage (4) et une face supérieure de celle-ci à l'opposé de ladite face inférieure.

32. Procédé selon la revendication 30, **caractérisé en ce que** ladite étape de revêtement implique toutes les faces de ladite structure ferromagnétique multicouche (3).

33. Procédé selon la revendication 30, **caractérisé en ce que** ledit dispositif électronique (11) est un dispositif à puces multiples.
